Europäisches Patentamt

European Patent Office

Office européen des brevets

(11) Veröffentlichungsnummer: **0 002 661**
A1

(19)

(12) # EUROPÄISCHE PATENTANMELDUNG

(21) Anmeldenummer: 78101265.3

(22) Anmeldetag: 31.10.78

(51) Int. Cl.²: **H 01 L 21/82, H 01 L 21/265**

(30) Priorität: 30.12.77 US 865805

(43) Veröffentlichungstag der Anmeldung: 11.07.79
Patentblatt 79/14

(84) Benannte Vertragsstaaten: **CH DE FR GB NL SE**

(71) Anmelder: **International Business Machines
Corporation, Armonk, N.Y. 10504 (US)**

(72) Erfinder: **Horng, Cheng Tzong, 22 Concord Road,
Fishkill New York 12524 (US)**
Erfinder: **Michel, Alwin Earl, 3 Grants Lane, Ossining
New York 10562 (US)**
Erfinder: **Rupprecht, Hans Stephan, 3505 Kamhi Drive,
Yorktown Heights New York 10598 (US)**
Erfinder: **Schwenker, Robert Otto, Pleasant Hill Road,
Hopewell Junction New York 12533 (US)**

(74) Vertreter: **Gaugel, Heinz, Dipl.-Ing., Schönaicher
Strasse 220, D-7030 Böblingen (DE)**

(54) Verfahren zum Herstellen von integrierten, bipolaren Transistoren.

(57) Bei einem Verfahren zum Herstellen von bipolaren Transistoren durch Ionenimplantation wird insbesondere die Basiszone (32) in eine auf ein Halbleitersubstrat (10) mit Subkollektor (14) epitaktisch aufgewachsene, die Kollektorzone bildende Halbleiterschicht (18) durch eine endgültig auf der Halbleiterschicht verbleibende, eine gleichmäßige Dicke aufweisende Siliciumdioxidschicht (20) hindurch implantiert. Anschließend werden Fenster (37, 36, 35) für den Emitterkontakt, den Basiskontakt und den Kollektorkontakt in der Siliciumdioxidschicht (20) geöffnet. Die Emitterzone (42) wird dann selektiv durch das Fenster (37) für den Emitterkontakt implantiert. Abschließend wird die die Kontakte und Verbindungsleitungen bildende Metallisierung auf die Siliciumdioxidschicht (20) aufgebracht.

Dieses Verfahren gewährleistet trotz direkter Implantation der Emitterzone eine gleichmäßige Dicke der die abschließende Metallisierung tragenden Isolierschicht, was zu gleichmäßigen und abschätzbaren Kapazitäten führt.

- 1 -

Verfahren zum Herstellen von integrierten, bipolaren Transistoren

Die Erfindung betrifft ein Verfahren zum Herstellen von integrierten, bipolaren Transistoren, deren Basiszone, Emitterzone und evtl. notwendige Kontakt- und Anschlußzonen durch Ionenimplantation in eine die Kollektorzone bildende Halbleiterschicht eingebracht werden.

Die in der integrierten Halbleitertechnik erzielten Fortschritte basieren im wesentlichen auf der Möglichkeit, die Eigenschaften der Halbleitermaterialien in definierter Weise beeinflussen zu können. Dabei werden die elektrischen Eigenschaften durch definierte, geringe Spuren von Dotierungsstoffen bestimmt. Ein bekanntes Verfahren zum Einbringen dieser Dotierungsstoffe ist die Ionenimplantation. Bei diesem Verfahren wird ein Strahl bestimmter, energiereicher Ionen auf die Oberfläche des Halbleitermaterials gerichtet. Die Ionen dringen bei geeigneter Wahl der Strahlenenergie in das Halbleitermaterial ein und bewirken dort physikalische, elektrische und/oder chemische Veränderungen.

Das Verfahren der Ionenimplantation bietet bei der Herstellung von integrierten Halbleiteranordnungen gegenüber dem konventionellen, thermischen Diffusionsverfahren eine Reihe von beträchtlichen Vorteilen. Da es sich bei der Ionenimplantation nicht um einen Hochtemperaturprozeß handelt, kann

FI 977 034

für die erforderlichen Maskierungsschichten, durch die die zu implantierenden Gebiete im Halbleiterkörper definiert werden, eine große Anzahl von Materialien verwendet werden, die organische Photolacke einschließen. Außerdem kann eine mehrfache Dotierung mit unterschiedlichen Dotierungsstoffen ohne die Anwendung von hohen Temperaturen erreicht werden. Hohe Temperaturen, wie sie bei der konventionellen thermischen Diffusion von Dotierungsstoffen auftreten, führen zu einer Ausdiffusion von zuvor eingebrachten Dotierungsstoffen. Das Verfahren der Ionenimplantation gestattet somit eine genauere Festlegung der Lage und der Tiefe der in einen Halbleiterkörper einzubringenden dotierten Zonen. Es läßt sich ganz allgemein feststellen, daß Lage, Ausdehnung, Tiefe und Konzentration einer durch Ionenimplantation hergestellten Halbleiterzone leichter und besser beherrschbar sind als dies bei der Anwendung von thermischer Diffusion möglich ist. Die Folge davon ist, daß sich mittels Ionenimplantation integrierte Halbleiteranordnungen herstellen lassen, die in verschiedener Hinsicht bessere Eigenschaften aufweisen. Insbesondere lassen sich durch Verringerung des Flächenbedarfs höhere Packungsdichten und höhere Arbeitsgeschwindigkeiten erreichen.

Mit der Erhöhung der Packungsdichte, also dem Kleinerwerden der einzelnen Halbleiterbauelemente, gewinnen die parasitären Kapazitäten an Einfluß, die in Verbindung mit der auf die Oberfläche der die integrierte Struktur enthaltenden Halbleiterschicht über einer passivierenden, dielektrischen Schicht aufzubringenden, die erforderlichen Leitungsverbindungen liefernden Metallisierung auftreten. Diese parasitären Kapazitäten lassen sich nicht verhindern, es ist jedoch wichtig, sie so gleichmäßig und abschätzbar zu machen wie möglich. Nur auf diese Weise läßt sich der Einfluß dieser Kapazitäten unter Kontrolle bringen. Einen wesentlichen Einfluß auf die Größe der parasitären Kapazität hat die Dicke der die genannte Metallisierung tragenden dielektrischen

FI 977 034

Schicht. Bei den in der Halbleitertechnik normalerweise angewandten Verfahren erfolgt die Dotierung sowohl bei der Ionenimplantation als auch bei der thermischen Diffusion über definierte Fenster aufweisende Maskierungsschichten auf der Halbleiteroberfläche. Diese Maskierungsschichten werden bei normalerweise aus Silicium bestehendem Halbleitermaterial durch thermische Oxidation der Oberfläche aufgebracht, sie bestehen also aus Siliciumdioxid. Nach der Dotierung wird die Halbleiteroberfläche reoxidiert. Da bei dieser thermischen Oxidation das für die Siliciumdioxidschicht erforderliche Silicium der Halbleiterschicht selbst entnommen wird, verschiebt sich die Trennfläche zwischen Siliciumdioxid und eigentlicher Halbleiterschicht. Dieser Effekt in Verbindung mit den ohnehin vorhandenen Dickenunterschieden der Oxidschicht, bedingt durch die gegenüber den restlichen Schichtbereichen geringere Dicke der durch Reoxidation erzeugten Schichtbereiche, ist für die beträchtlichen Dickenunterschiede innerhalb der am Ende für die Metallisierung zur Verfügung stehenden dielektrischen Schicht verantwortlich. Da die angesprochene parasitäre Kapazität aus dieser Metallisierung als einer Kondensatorplatte, der Halbleiterschicht als der anderen Kondensatorplatte und der Siliciumdioxidschicht als Dielektrikum besteht, hängt ihre Größe in beträchtlichem Maße von der Dicke dieses Dielektrikums ab. Variiert diese Dicke innerhalb der Oxidschicht, so sind die auftretenden unterschiedlichen Größen der parasitären Kapazität nicht abschätzbar. Hier will die Erfindung Abhilfe schaffen. Die Erfindung, wie sie in den Ansprüchen gekennzeichnet ist, löst die Aufgabe, ein Verfahren zum Herstellen von bipolaren Transistoren durch Ionenimplantation anzugeben, bei dem die am Ende des Verfahrens zur Verfügung stehende dielektrische Schicht, auf die die Metallisierung aufgebracht wird, eine gleichmäßige Dicke aufweist. Die in Verbindung mit der Metallisierung auftretenden parasitären Kapazitäten sind bei gleichmäßiger Dicke der dielektrischen Schicht ebenfalls gleichförmig und abschätzbar. Außerdem wird das Ätzen der

FI 977 034

Maskenfenster für die aufzubringenden Kontakte beträchtlich erleichtert.

Im folgenden wird die Erfindung an Hand von Zeichnungen näher erläutert. Es zeigen:

Fign. 1 - 10    eine Folge von Schnittansichten einer in einem erfindungsgemäßen Herstellungsverfahren hergestellten Struktur jeweils am Ende aufeinanderfolgender Prozeßschritte und

Fign.11 und 12 die die Prozeßschritte gemäß Fign. 1 bis 10 ergänzenden Schnittansichten einer, in einem abgewandelten erfindungsgemäßen Verfahren hergestellten Struktur.

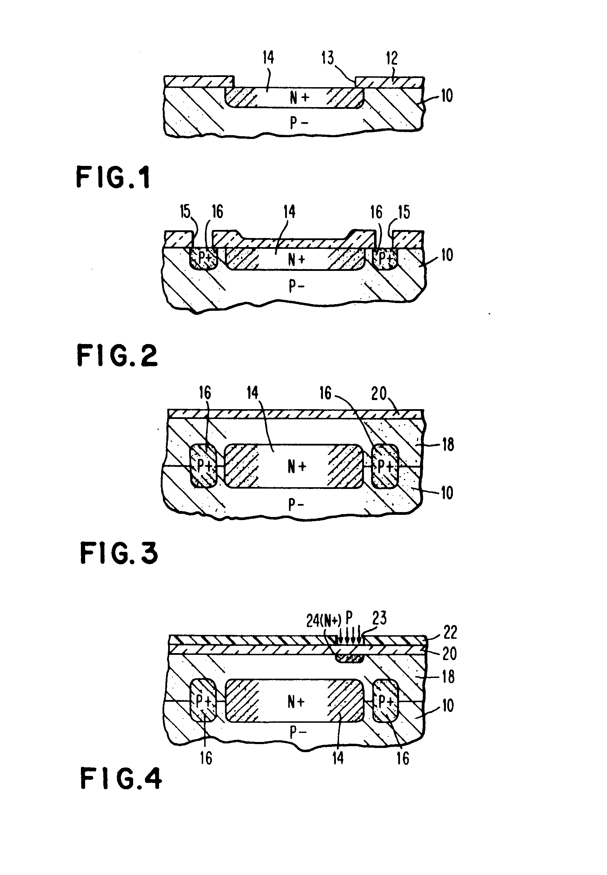

Wie aus Fig. 1 zu ersehen, wird bei einem Ausführungsbeispiel des erfindungsgemäßen Verfahrens von einem $P^-$-dotierten Halbleitersubstrat 10 aus monokristallinem Silicium ausgegangen. Durch Oxidation der Oberfläche des Halbleitersubstrats ist eine Maskierungsschicht 12 aus Siliciumdioxid gebildet. Auf konventionellem, photolithographischem Wege ist in der Maskierungsschicht 12 ein einen einzubringenden Subkollektor definierendes Fenster 13 freigelegt. Im Bereich dieses Fensters 13 wird die den Subkollektor bildende, $N^+$-dotierte Zone 14 eingebracht. Als Störstellenmaterial kann beispielsweise Arsen verwendet werden. Das Eindringen des Störstellenmaterials kann beispielsweise durch Diffusion oder auch Ionenimplantation erfolgen. Anschließend wird, wie in Fig. 2 gezeigt, die Oberfläche reoxidiert, so daß die Maskierungsschicht im Bereich des Subkollektors 14 erneut gebildet wird. Wiederum auf photolithographischem Wege werden die ringförmige Subisolationszone definierende Fenster 15 gebildet. Im Bereich dieser Fenster werden die $P^+$-dotierten Subisolationszonen 16 in das Halbleitersubstrat eingebracht. Als Störstellenmaterial

FI 977 034

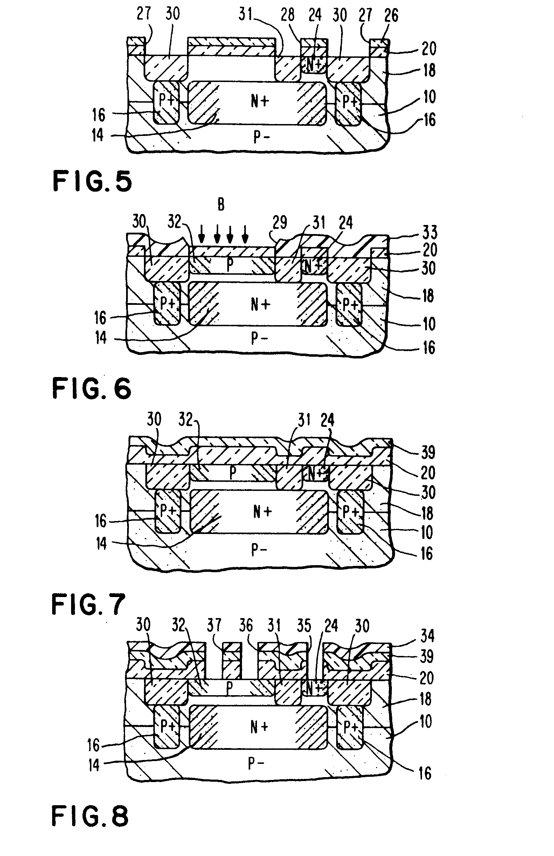

eignet sich beispielsweise Bor. Das Einbringen kann durch Diffusion oder Implantation erfolgen. Wie in Fig. 3 gezeigt, wird nunmehr die Maskierungsschicht 12 entfernt und auf epitaktischem Wege eine Halbleiterschicht 18 auf die Oberfläche des Halbleitersubstrats 10 aufgebracht. Während des Epitaxieprozesses, der einen Hochtemperaturprozeß darstellt, diffundiert die Subkollektorzone 14 und die Subisolationszone 16 nach oben in die epitaktische Halbleiterschicht 18 aus. Die Oberfläche der Halbleiterschicht 18 wird in einer geeigneten oxidierenden Atmosphäre, beispielsweise in einer Dampfatmosphäre bei 800 $^{\circ}$C, oxidiert, wobei sich eine durchgehende dielektrische Schicht 20 aus thermischen Oxid bildet. Die Dicke der dielektrischen Schicht 20 wird im Bereich zwischen 50 und 250 nm liegen, vorzugsweise wählt man eine Dicke von etwa 80 nm. Die dielektrische Schicht 20 aus Siliciumdioxid bildet bereits die endgültig auf der Struktur verbleibende Schicht. Auf die dielektrische Schicht wird nunmehr eine Photolackschicht 22 aufgebracht (Fig. 4). Diese Photolackschicht dient als Implantationsmaske für eine N$^{+}$-dotierte Kollektoranschlußzone und wird deshalb mit einem entsprechenden Fenster 23 ausgestattet. Die Implantation von N-Störstellenmaterial erfolgt mit ausreichender Energie, so daß die dielektrische Schicht 20 durchdrungen wird. Vorzugsweise wird Phosphor mit einer Energie von 180 bis 400 keV in einer Dosis von 2 bis 3 x $10^{15}$ Ionen/cm$^2$ implantiert. Auf diese Weise erhält man die Kollektoranschlußzone 24. In manchen Anwendungsfällen kann auf eine solche Kollektoranschlußzone verzichtet werden, wenn ein erhöhter Kollektorwiderstand in Kauf genommen werden kann. Nunmehr wird die Photolackschicht 22 entfernt (Fig. 5). Auf die dielektrische Schicht 20 wird eine Siliciumnitridscchicht 26 aufgebracht. Diese Siliciumnitridschicht 26 dient als Maske zur Verhinderung einer Oxidation der darunterliegenden Gebiete der epitaktischen Halbleiterschicht 18 während der nachfolgend zu beschreibenden Herstellung abgesenkter Oxidzonen als Isolationszonen. Für das Öffnen der Fenster in der Siliciumnitridschicht 26 wird zunächst in einem konventionellen chemischen Aufdampfprozeß eine in der Zeichnung nicht dargestellte Siliciumdioxidschicht auf die Siliciumnitridschicht aufgebracht. Mit Hilfe einer weiteren aufgebrachten Photolackschicht werden in der Siliciumdioxidschicht auf photolithographischem Wege Fenster freigelegt, die über den Subisolationszonen 16 liegen. Ein weiteres Fenster wird in einem Bereich freigelegt, in dem ebenfalls durch eine Isolationszone die Basis- und Emitterzone von der Kollektoranschlußzone 24 zu trennen ist. Die im Bereich der gebildeten Fenster in der Siliciumdioxidschicht freiliegenden Bereiche der Siliciumnitridschicht 26 werden nun entfernt, so daß die Öffnungen 27 über den Subisolationszonen 16 und die Öffnung 28 über der die Kollektoranschlußzone von der Basiszone trennenden, noch zu bildenden Isolationszone freigelegt werden. Durch konventionelle Ätztechnik werden die im Bereich der gebildeten Fenster liegenden Bereiche der dielektrischen Schicht 20 entfernt. Die auf diese Weise gebildete Maske für die Herstellung der Isolationszonen wird verwendet, um im Bereich der Fenster 27 und 28, beispielsweise durch reaktives Ionenätzen, die epitaktische Schicht bis zu etwa der halben Tiefe der zu bildenden abgesenkten Oxidzonen zu entfernen. Bei diesem Ätzprozeß wird normalerweise die über der Siliciumnitridschicht 26 liegende Siliciumdioxidschicht entfernt. In oxidierender Atmosphäre werden dann die Isolationszonen in Form abgesenkter Oxidzonen 30 und 31 gebildet. Als oxidierende Atmosphäre dient beispielsweise Wasserdampf bei 1000 °C. Während dieses Erwärmungsprozesses diffundiert die Kollektoranschlußzone 24 in Richtung auf den Subkollektor 14 aus und erreicht diesen fast oder sogar ganz. Wie der Fig. 6 zu entnehmen ist, wird die Siliciumnitridschicht 26 entfernt und eine Photolackschicht 33 auf die Oberfläche der Struktur aufgebracht. In der Photolackschicht 33 wird durch geeignete Belichtung und Entwicklung ein Fenster 29 freigelegt, das sich über den Bereich der zu bilden-

FI 977 034

den Basiszone des Transistors erstreckt. Die Photolackschicht 33 wird als Implantationsmaske zur Herstellung der Basis verwendet. Die Basiszone 32 entsteht durch Implantation von geeignetem P-Störstellenmaterial durch die dielektrische Schicht 20 hindurch in die epitaktische Halbleiterschicht 18. Vorzugsweise wird die Basiszone 32 durch Implantation von Bor bei zwei unterschiedlichen Energiepegeln gebildet. Beispielsweise wird eine erste Implantation mit 50 keV und einer Dosis von $1,5 \times 10^{14}$ Ionen/$cm^2$ und eine zweite Implantation mit 150 keV und einer Dosis von $2 \times 10^{13}$ Ionen/$cm^2$ durchgeführt. In dieser Herstellungsstufe können auch Widerstände in verschiedenen Teilen der Struktur dadurch gebildet werden, daß die Photolackschicht 33 entfernt und eine weitere Photolackschicht aufgebracht wird. Diese weitere Photolackschicht dient dann als Implantationsmaske für die zu bildenden Widerstandszonen, die ebenfalls durch die dielektrische Schicht 20 hindurch in die epitaktische Halbleiterschicht 18 eingebracht werden.

Nach diesem Implantationsprozeß wird die Photolackschicht wiederum entfernt. Wie in Fig. 7 angedeutet, kann die Dicke der dielektrischen Schicht 20 vergrößert werden. Die anfängliche Dicke dieser Schicht ist so gewählt, daß für die durchzuführenden Implantationen optimale Bedingungen erreicht werden. Die Dicke der Schicht kann dann vorzugsweise in einem chemischen Aufdampfprozeß von Siliciumdioxid erhöht werden. Die dabei gewählte Dicke der Schicht 20 ist so wählbar, daß sich vorteilhafte Eigenschaften für die fertige Transistorstruktur ergeben. Außerdem wird ebenfalls in einem chemischen Aufdampfprozeß eine Siliciumnitridschicht 39 auf die dielektrische Schicht 20 aufgebracht. Die Erhöhung der Dicke der dielektrischen Schicht 20 und das Aufbringen einer zusätzlichen Siliciumnitridschicht 39 ist nicht in jedem Anwendungsfalle erforderlich und kann wahlweise vorgenommen werden.

FI 977 034

Der Fig. 8 ist zu entnehmen, daß auf die Silicumnitridschicht 39 wiederum eine Photolackschicht 34 aufgebracht wird, die nach geeigneter Belichtung und Entwicklung ein Fenster 35 für den Kollektorkontakt, ein Fenster 36 für den Basiskontakt und ein Fenster 37 für den Emitterkontakt bzw. die Emitterzone erhält. Diese Photolackschicht 34 dient als Ätzmaske zur Freilegung entsprechender Fenster in der Siliciumnitridschicht 39 (falls vorhanden) und der dielektrischen Isolationsschicht 20. Dies geschieht vorzugsweise durch reaktives Ionenätzen, das die Entstehung von Fenstern gewährleistet, die senkrechte Seitenwände ohne wesentliche Unterätzungen aufweisen.

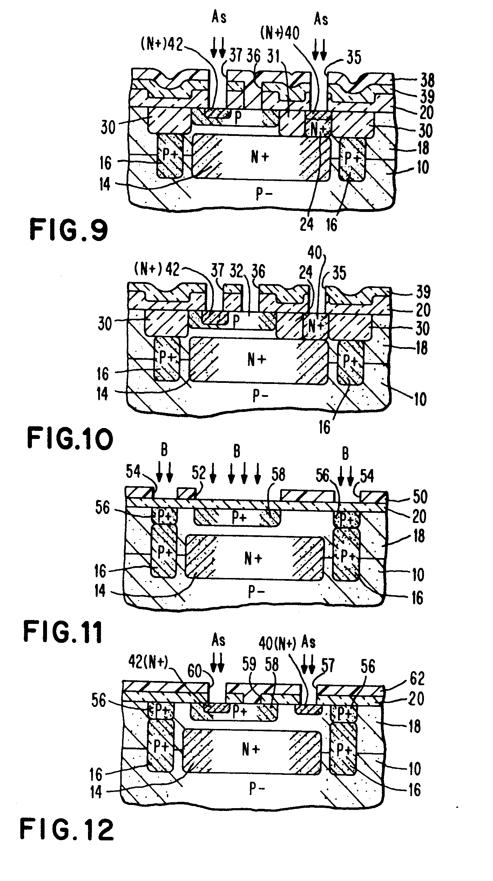

Der nächste Prozeßschritt ergibt sich aus der Fig. 9. Zunächst wird die Photolackschicht 34 entfernt und durch eine weitere Photolackschicht 38 über der Siliciumnitridschicht 39 ersetzt. Die Photolackschicht 38 erhält durch Belichtung und Entwicklung Fenster im Bereich der Fenster 35 und 37, die den Kollektorkontakt und die Emitterzone definieren, und hat gleichzeitig die Aufgabe, das in Fig. 8 gezeigte Fenster 36 für den Basiskontakt zu bedecken. Die auf diese Weise gebildete Photolackschicht 38 dient als Implantationsmaske für den nachfolgenden Implantationsprozeß, bei dem N-Störstellenmaterial, beispielsweise Arsen, mit einer Energie in der Größenordnung von 40 keV und einer Dosis von 7,5 bis 8 x $10^{15}$ Ionen/$cm^2$ implantiert wird. Bei dieser Implantation entstehen die $N^+$-dotierte Kollektorkontaktzone 40 und die $N^+$-dotierte Emitterzone 42. Anschließend wird die Photolackschicht 38 entfernt und es folgt ein Erwärmungsprozeß, bei dem die implantierten Zonen aktiviert und weiter in die epitaktische Halbleiterschicht 18 eingetrieben werden. Außerdem werden bei diesem Erwärmungsprozeß die während der vorausgegangenen Ionenimplantationen entstanden Gitterstörungen im Halbleitermaterial beseitigt. Die gewählte Temperatur liegt im Bereich von 900 bis 1100 $^{o}$C, vorzugsweise bei 1000 $^{o}$C. Die Dauer des Erwärmungsprozesses hängt von der Dosis er verschiedenen implantierten Zonen ab. Im allgemeinen liegt die Dauer im Bereich zwischen 50 Minuten und 2 Stunden. Wie in Fig. 10 angedeutet, dehnt sich die Emitterzone 42 weiter in die epitaktische Halbleiterschicht 18 aus und die Kollektorkontaktzone 40 verschmilzt mit der Kollektoranschlußzone 24.

Die in Fig. 10 dargestellte Struktur ist nun soweit fertiggestellt, daß der Metallisierungsprozeß durchgeführt werden kann, bei dem die notwendigen Kontakte, leitenden Zwischenverbindungen zwischen den einzelnen Bauelementen und anderen auf dem gleichen Halbleitersubstrat 10 angeordneten Schaltungen hergestellt werden. Dieser Metallisierungsprozeß ist hinreichend bekannt und wird deshalb nicht näher beschrieben.

Das an Hand der Fign. 1 bis 10 beschriebene Herstellungsverfahren liefert einen P-Transistor. Selbstverständlich läßt sich im Rahmen des erfindungsgemäßen Verfahrens in gleicher Weise ein komplementärer Transistortyp herstellen.

Es sei nunmehr auf die Fign. 11 und 12 Bezug genommen, die ein weiteres bevorzugtes, spezielles Ausführungsbeispiel des erfindungsgemäßen Verfahrens wiedergeben. Bei diesem Verfahren wird anstelle der im ersten Verfahren beschriebenen Isolation durch abgesenkte Oxidzonen eine Sperrschichtisolation angewendet. Die an Hand der Fign. 1 bis 3 beschriebenen Verfahrensschritte zur Herstellung einer Subkollektorzone 14, einer ringförmigen Subisolationszone 16 und der dielektrischen Schicht 20 bleiben bei dem abgewandelten Verfahren erhalten. Wie in Fig. 11 angedeutet ist, werden die Störstellen für die Subkollektorzone 14 und die Subisolationszone 16 so ausgewählt, daß die Subisolationszone 16 mit höherer Diffusionsrate in die epitaktische Halbleiterschicht 18 ausdiffundiert als die Subkollektorzone 14. Auf der dielektrischen Schicht 20 aus Siliciumdioxid wird eine Photolackschicht 50 aufge-

FI 977 034

bracht, die nach entsprechender Belichtung und Entwicklung als Implantationsmaske verwendet wird und das Fenster 52 für die Basiszone und das Fenster 54 für die Isolationszone über der Subisolationszone 16 definiert. Im Bereich dieser Fenster 52 und 54 wird durch Implantation von P-Störstellenmaterial die Basiszone 58 und die Isolationszone 56 hergestellt. Die Ionenimplantation erfolgt durch die dielektrische Schicht 20 hindurch, die endgültig auf der zu bildenden Struktur verbleibt. Die Photolackschicht 50 wird entfernt und durch eine weitere, nicht dargestellte Photolackschicht ersetzt, die nach entsprechender Belichtung und Entwicklung als Ätzmaske zur Herstellung des Fensters 57 für den Kollektorkontakt, des Fensters 59 für den Basiskontakt und des Fensters 60 für die Emitterzone bzw. den Emitterkontakt verwendet. Diese nicht dargestellte Photolackschicht wird dann entfernt. Eine neue aufgebrachte Photolackschicht 62 dient, wie in Fig. 12 dargestellt, nach entsprechender Belichtung und Entwicklung, zur Herstellung der Fenster 57 und 60 und Abdeckung des Fensters 59. Im Bereich dieser geöffneten Fenster 57 und 60 werden durch Implantation von N-Störstellenmaterial die Emitterzone 42 und die Kollektorkontaktzone 40 hergestellt. Diese Implantation wird unter denselben Bedingungen durchgeführt, wie sie in Verbindung mit Fig. 9 beschrieben ist. Anschließend wird die Photolackschicht 62 entfernt und die Struktur einem Erwärmungsprozeß unterworfen, der dem in Verbindung mit Fig. 10 beschriebenen Erwärmungsprozeß entspricht.

Nach diesem Verfahrensschritt erfolgt die Metallisierung über der dielektrischen Schicht 20 zur Herstellung der Kontakte und elektrischen Verbindungen.

Die Dicke der dielektrischen Schicht 20 aus Siliciumdioxid kann, falls erwünscht, nach der Implantation der Isolationszone und der Basiszone erhöht werden.

FI 977 034

Die in Fig. 4 gezeigte Kollektoranschlußzone 24 kann selbstverständlich auch in die Struktur gemäß Fig. 11 eingebracht
werden.

- 1 -

P A T E N T A N S P R Ü C H E

1. Verfahren zum Herstellen von integrierten, bipolaren Transistoren, deren Basiszone, Emitterzone und evtl. notwendige Kontakt- und Anschlußzonen durch Ionenimplantation in eine die Kollektorzone bildende Halbleiterschicht (18) eingebracht werden, dadurch gekennzeichnet,

daß auf die Oberfläche der die Transistorstruktur aufnehmenden Halbleiterschicht (18) eine endgültig dort verbleibende dielektrische Schicht (20) gleichmäßiger Dicke aufgebracht wird,

daß mit Ausnahme der Emitterzone (42) die Zonen der Transistorstruktur durch definierte Implantationen durch die dielektrische Schicht (20) hindurch eingebracht werden,

daß in die dielektrische Schicht (20) Fenster (37, 36, 35) für den Emitterkontakt, den Basiskontakt und den Kollektorkontakt geöffnet werden,

daß die Emitterzone (42) durch das Fenster (37) für den Emitterkontakt implantiert wird und

daß schließlich durch eine auf die dielektrische Schicht (20) aufgebrachte Metallisierung die Zonen kontaktiert werden.

2. Verfahren nach Anspruch 1, dadurch gekennzeichnet, daß die Halbleiterschicht (18) eines ersten Leitungstyps über einem in ein Halbleitersubstrat (10) des zweiten

FI 977 034

Leitungstyps eingebrachten Subkollektor (14) des ersten Leitungstyps epitaktisch aufgewachsen wird, daß die dielektrische Schicht (20) auf die Oberfläche der Halbleiterschicht (18) aufgebracht wird, daß eine mindestens den über dem Subkollektor (14) liegenden Bereich der Halbleiterschicht (18) einschließende Isolationszone (16, 30, 56) in die Halbleiterschicht eingebracht wird,

daß die Basiszone (32) des zweiten Leitungstyps durch die dielektrische Schicht (20) hindurch über den Subkollektor (14) in die Halbleiterschicht (18) implantiert wird,

daß in der dielektrischen Schicht (18) die Fenster (37, 36, 35) für Emitter-Basis- und Kollektorkontakt geöffnet werden,

daß nach selektiver Maskierung des Fensters (36) für den Basiskontakt, die Kollektorkontaktzone (40) und die Emitterzone (42) des ersten Leitungstyps durch die Fenster (35, 37) für Kollektor- und Emitterkontakt implantiert werden,

daß ein Erwärmungsprozeß zur Aktivierung der implantierten Zonen durchgeführt wird und

daß schließlich auf die dielektrische Schicht (20) eine Kontakte und Leitungsmuster bildende Metallisierung aufgebracht wird.

3. Verfahren nach Anspruch 2, dadurch gekennzeichnet, daß die Basiszone (32) mit Hilfe einer auf die dielektrische Schicht (20) aufgebrachten ersten, als Implantationsmaske dienenden Photolackschicht (33) implantiert wird,

daß nach Entfernung der ersten Photolackschicht (33) mit Hilfe einer als Ätzmaske dienenden zweiten Photolackschicht (34) die Fenster (37, 36, 35) für Emitter-Basis- und Kollektorkontakt geöffnet werden und

FI 977 034

daß nach Entfernung der zweiten Photolackschicht (34) die selektive Maskierung des Fensters (36) für den Basiskontakt mit Hilfe einer als Implantationsmaske dienenden dritten Photolackschicht (38) erfolgt.

4. Verfahren nach Anspruch 2, dadurch gekennzeichnet, daß der Erwärmungsprozeß zur Aktivierung der implantierten Zonen mit einer Temperatur im Bereich von 900 bis 1100 $^{O}$C durchgeführt wird.

5. Verfahren nach den Ansprüchen 1 bis 4, dadurch gekennzeichnet, daß die dielektrische Schicht (20) aus einer durch thermische Oxidation der Oberfläche der Halbleiterschicht (18) erzeugten Siliciumdioxidschicht besteht und eine Dicke im Bereich von 50 bis 250 nm aufweist.

6. Verfahren nach Anspruch 5, dadurch gekennzeichnet, daß nach Entfernung der ersten Photolackschicht (33) eine zusätzliche Siliciumdioxidschicht auf die dielektrische Schicht (20) aufgebracht wird, so daß sich eine Gesamtschichtdicke von 100 bis 300 nm ergibt.

7. Verfahren nach den Ansprüchen 2 bis 6, dadurch gekennzeichnet, daß das Öffnen der Fenster (37, 36, 35) für Emitter-Basis- und Kollektorkontakt durch reaktives Ionenätzen erfolgt.

8. Verfahren nach den Ansprüchen 1 bis 7, dadurch gekennzeichnet, daß nach dem Aufbringen der dielektrischen Schicht (20) auf die Halbleiterschicht (18) mittels einer als Implantationsmaske dienenden Photolackschicht (22 in Fig. 4) über einem Teilbereich des Subkollektors (14) eine Kollektoranschlußzone (24) des ersten Leitungstyps in die Halbleiterschicht (18) implantiert wird.

FI 977 034

9. Verfahren nach den Ansprüchen 2 bis 8, dadurch gekennzeichnet,

daß die mindestens den über dem Subkollektor (14) liegenden Bereich der Halbleiterschicht (18) einschließende Isolationszone dadurch erzeugt wird, daß auf die dielektrische Schicht (20) aus Siliciumdioxid zunächst eine Siliciumnitridschicht aufgebracht wird, daß im Bereich der zu bildenden Isolationszone ein Fenster in beiden Schichten geöffnet wird, daß im Bereich dieser Fenster Teile der Halbleiterschicht (18) entfernt werden und daß in einem Oxidationsprozeß in diesem Bereich abgesenkte, dielektrische Isolationszonen (30) aus Siliciumdioxid gebildet werden.

10. Verfahren nach den Ansprüchen 2 bis 8, dadurch gekennzeichnet,

daß die mindestens den über dem Subkollektor (14) liegenden Bereich der Halbleiterschicht (18) einschließende Isolationszone dadurch hergestellt wird, daß in die Halbleiterschicht (18) eine Isolationszone (56, Fig. 11) des zweiten Leitungstyps implantiert wird.

11. Verfahren nach Anspruch 9 oder 10, dadurch gekennzeichnet,

daß in das Halbleitersubstrat (10) eine den Subkollektor (14) umgebende Subisolationszone (16) des zweiten Leitungstyps eingebracht wird, die zusammen mit der dielektrischen Isolationszone (30) oder der eine Sperrschicht bildenden Isolationszone (16) des zweiten Leitungstyps die Isolation der Struktur bewirkt.

FI 977 034

FIG.1

FIG.2

FIG.3

FIG.4

FIG.5

FIG.6

FIG.7

FIG.8

FIG.9

FIG.10

FIG.11

FIG.12

| Kategorie | EINSCHLÄGIGE DOKUMENTE | | KLASSIFIKATION DER ANMELDUNG (Int.Cl.²) |
|---|---|---|---|
| | Kennzeichnung des Dokuments mit Angabe, soweit erforderlich, der maßgeblichen Teile | betrifft Anspruch | |
| X | US. - A - 3 925 105 (B.J. SLOAN)<br><br>* Figur 1; Spalte 3, Zeile 14 - Spalte 6, Zeile 35 *<br><br>--- | 1-6,10 | H 01 L 21/82<br>21/265 |
| X | IBM TECHNICAL DISCLOSURE BULLETIN, Band 20, Oktober 1977, New York, USA, C.H. LEE "Bipolar transistor fabrication process", Seiten 1753-1754<br><br>* Seiten 1753-1754 *<br><br>--- | 1-3, 7-9,11 | RECHERCHIERTE SACHGEBIETE (Int. Cl.²) |
| | FR - A - 2 209 217 (LIGNES TELE-GRAPHIQUES ET TELEPHONIQUES)<br><br>* Ansprüche; Figuren 2-4 *<br><br>& DE - A - 2 356 109<br><br>--- | 1 | H 01 L 21/82<br>21/265<br>21/00 |
| P | IBM TECHNICAL DISCLOSURE BULLETIN, Band 21, September 1978, New York, USA, R.K. RAHEJA "Method for forming bipolar integrated circuits having surface passivating layers of uniform thickness", Seiten 1439-1440<br><br>* Seiten 1439-1440 *<br><br>---- | 1-3,5, 8 | |

**KATEGORIE DER GENANNTEN DOKUMENTE**

X: von besonderer Bedeutung

A: technologischer Hintergrund

O: nichtschriftliche Offenbarung

P: Zwischenliteratur

T: der Erfindung zugrunde liegende Theorien oder Grundsätze

E: kollidierende Anmeldung

D: in der Anmeldung angeführtes Dokument

L: aus andern Gründen angeführtes Dokument

&: Mitglied der gleichen Patentfamilie, übereinstimmendes Dokument

Der vorliegende Recherchenbericht wurde für alle Patentansprüche erstellt.

| Recherchenort | Abschlußdatum der Recherche | Prüfer |
|---|---|---|
| Den Haag | 09-03-1979 | CARDON |

EPA form 1503.1   06.78